# EUROPEAN PATENT SPECIFICATION

(11) **EP 1 487 246 B1**
(45) Date of publication and mention of the grant of the patent: **16.07.2008**
(21) Application number: 04253392.7
(22) Date of filing: 07.06.2004
(51) Int. Cl.: H05K 3/28, B29C 45/14

(54) **Resin encapsulated electronic component unit and method of manufacturing the same**
Harzverkapselter elektronischer Bauteil und Verfahren zu seiner Herstellung
Composant électronique encapsulé dans la résine et sa méthode de fabrication

(30) Priority: 06.06.2003 JP 2003161444; 06.06.2003 JP 2003161445; 06.06.2003 JP 2003161448
(43) Date of publication of application: 15.12.2004
(73) Proprietor: HONDA MOTOR CO., LTD., Tokyo 107-8556 (JP)
(72) Inventor: Kimata, Ryuichi c/o K.K. Honda Gijyutsu Kenkyusho, Wako-shi, Saitama 351-0193 (JP); Wakitani, Tsutomu c/o K.K Honda Gijyutsu Kenkyusho, Wako-shi, Saitama 351-0193 (JP); Yamashita, Kousei c/o K.K Honda Gijyutsu Kenkyusho, Wako-shi, Saitama 351-0193 (JP); Kato, Hironori c/o K.K. Honda Gijyutsu Kenkyusho, Wako-shi, Saitama 351-0193 (JP)
(74) Representative: Cheyne, John Robert Alexander M.

(56) References cited:
- DE-A- 10 013 255
- FR-A- 2 753 044
- US-A- 5 248 852
- US-A- 5 319 522
- US-B1- 6 403 009

## Description

### BACKGROUND OF THE INVENTION

### Field of the Invention

The present invention relates to a resin encapsulated electronic component unit which is obtained by coating and encapsulating, with a resin coating layer, a printed circuit board on which electronic components, such as capacitors and cable connection members, are mounted, and a method of manufacturing this resin encapsulated electronic component unit.

### Description of the Related Art

In order to protect a printed circuit board, on which electronic components such as capacitors and cable connection members are mounted, from water, moisture or dust, there has hitherto been known a resin encapsulated electronic component unit which is obtained by coating and encapsulating the board with a resin coating layer.

Some of the above-described resin encapsulated electronic component units, for example, have the whole of the above-described printed circuit board, on which electronic components are mounted, coated with a resin such as an epoxy resin. Such a resin encapsulated electronic component unit is manufactured, as described in the Japanese Utility Model Registration No. 6-11535, for example, by housing the above-described printed circuit board in a case and injecting an epoxy resin into the case.

The above-described epoxy resin is excellent in environmental resistance and has good adhesion to the above-described printed circuit board. Therefore, the above-described resin encapsulated electronic component unit has excellent waterproof, moisture-proof or dustproof performance. However, because the above-described epoxy resin is a thermosetting resin, it is necessary to hold this resin at a temperature of not less than 100°C for several hours after it is injected into the above-described case. Therefore, the manufacturing of the above-described resin encapsulated electronic component unit by using the above-described epoxy resin has the problem that the work efficiency is low and that the upsizing of equipment is unavoidable.

Furthermore, when manufacturing is performed in a manner as described above, a resin is injected into a case which houses the above-described printed circuit board and, therefore, it is necessary to inject the resin in an amount large enough to bury the tallest component among the electronic components mounted on the above-described printed circuit board. Therefore, this manufacturing method has the problem that the amount of the above-described resin to be injected cannot be reduced less than the amount necessary for embedding the above-described tallest component.

In order to solve the above-described problems, in the Japanese Patent Laid-Open No. 2000-133665 is proposed a technique by which a printed circuit board on which electronic components are mounted is coated by the insert molding of a thermoplastic resin. According to the above-described technique, it is possible to obtain a resin encapsulated electronic component unit by forming resin coating layer of the above-described thermoplastic resin and coating and encapsulating this board with the resin coating layer.

The above-described insert molding is performed by disposing the above-described printed circuit board within a cavity of a mold and injecting a thermoplastic resin such as a polyamide resin into this cavity. The above-described thermoplastic resin such as a polyamide resin melts at relatively low temperatures and can be injected at relatively low pressures. Therefore, according to the above-described insert molding, it is possible to prevent electronic components mounted on the above-described printed circuit board from being damaged by heat and pressure during molding.

However, the above-described insert molding has the disadvantage that the above-described thermoplastic resin injected into the above-described mold is divided into multiple streams within the above-described cavity, which flow around within the cavity, forming weld lines at points where the streams join together. If the above-described weld lines are formed in the above-described resin coating layer, cracks are liable to start at the weld lines when stresses are applied after molding.

DE10013255 discloses a resin-sealed electronic component comprising a hybrid integrated circuit substrate and a power semiconductor connected to a heat sink by an Sn-Sb alloy solder.

US6403009 discloses a method for encapsulating a circuit on a circuit board in which a first mold section closes on one side of the circuit board and a second mold section closes on the other side of the circuit board to form a mold cavity.

### SUMMARY OF THE INVENTION

According to one aspect of the present invention there is provided a resin encapsulated electronic component unit comprising a rectangular printed circuit board, electronic components mounted to the circuit board by means of a solder, and a resin coating layer which covers the electronic components by insert molding and encapsules the electronic components, the resin coating layer being formed from a thermoplastic resin whose temperature at a surface of the printed circuit board during the insert molding is lower than the melting temperature of the solder used to mount the electronic components to the circuit board, accessory members being connected to both end portions of narrow sides of the printed circuit board and molded integrally with the resin coating layer from the thermoplastic resin, the resin coating layer being formed by causing the thermoplastic resin to flow from the side of one accessory member to the side of the other accessory member characterised in that the solder is an alloy of Pb 60 wt% and Sn 40 wt% and that the thermoplastic resin is a polyamide resin.

According to another aspect of the present invention there is provided a method of manufacturing a resin encapsulated electronic component unit comprising a rectangular printed circuit board, electronic components mounted to the circuit board by means of a solder, a resin coating layer which covers the electronic components by insert molding and encapsulates the electronic components, the resin coating layer being formed from a thermoplastic resin whose temperature at a surface of the printed circuit board during the insert molding is lower than the melting temperature of the solder used to mount the electronic components to the circuit board, and accessory members which are connected to both end portions of narrow sides of the printed circuit board and molded integrally with the resin coating layer from the thermoplastic resin,
wherein the insert molding is performed by use of a mold which comprises a cavity in which the printed circuit board is disposed, and hollow portions corresponding to the shape of the accessory members formed between each end portion on narrow sides of said printed circuit board disposed within the cavity and an inner wall of the cavity, and by injecting the thermoplastic resin into one hollow portion and discharging gases in the cavity from the other hollow portion so that the thermoplastic resin flows within the cavity longitudinally of the board characterised in that the solder is an alloy of Pb 60 wt% and Sn 40 wt% and that the thermoplastic resin is a polyamide resin.

A preferred embodiment in accordance with the present invention provides a resin encapsulated electronic component unit in which a resin coating layer formed by insert molding has no weld line and is less apt to develop cracks even when stresses are applied.

In the manufacturing method of the present invention, the above-described rectangular printed circuit board is disposed within the cavity of the above-described mold. And the above-described thermoplastic resin is injected from a hollow portion corresponding to the shape of the above-described accessory member provided on one narrow side of the above-described board and gases in the cavity are discharged from the above-described hollow portion provided on the other narrow side.

As a result, the above-described thermoplastic resin flows within the above-described cavity longitudinally of the above-described board and the thermoplastic resin is filled in the cavity without being divided into multiple currents. Therefore, points where the multiple streams join together are not formed within the above-described cavity and it is possible to prevent weld lines from occurring in the above-described resin coating layer.

The above-described accessory members are, for example, attaching members which attach the above-described resin encapsulated electronic component unit in a predetermined position.

By using a thermoplastic resin whose temperature at a surface of the above-described printed circuit board during the above-described insert molding is lower than the melting temperature of a solder used in mounting the above-described electronic components, the melting of the above-described solder can be prevented.

Even when the above-described thermoplastic resin is used, the temperature of the thermoplastic resin becomes relatively high near a gate when the thermoplastic resin is injected into the above-described cavity. Therefore, when the above-described electronic components are present near the above-described gate, the electronic components are exposed to the thermoplastic resin at a relatively high temperature until the injection of the above-described thermoplastic resin is completed, with the result that the above-described solder may sometimes melt.

In the above-described manufacturing method, however, the above-described thermoplastic resin is injected into the above-described hollow portion and, therefore, the thermoplastic resin is cooled within the hollow portion, with the result that the temperature of the thermoplastic resin decreases sufficiently before the thermoplastic resin reaches points where the above-described electronic components of the above-described printed circuit board are mounted. Therefore, it is possible to prevent the above-described electronic components from being subjected to the above-described thermoplastic resin at a relatively high temperature while the thermoplastic resin is being injected.

Because a resin encapsulated electronic component unit of the present invention obtained as described above has the above-described resin coating layer free from a weld line, the resin coating layer is less apt to develop cracks even when stresses are applied and it is possible to obtain excellent waterproofness, moisture-proofness and dustproofness.

Incidentally, it is feared that the above-described resin coating layer might undergo heat contraction during cooling and hardening, with the result that deformation such as bowing might occur on the above-described printed circuit board due to stresses caused by the heat contraction.

Therefore, in a resin encapsulated electronic component unit of the present invention, the above-described resin coating layer is disposed on both front and back surfaces of the above-described printed circuit board and the amount of the above-described thermoplastic resin which forms the resin coating layer is substantially symmetrically disposed on both front and back surfaces of the printed circuit board.

Because in a resin encapsulated electronic component unit of the present invention, the amount of the above-described thermoplastic resin which forms the above-described resin coating layer is substantially symmetrically disposed on both front and back surfaces of the above-described printed circuit board, the amount of the thermoplastic resin becomes almost equal on both front and rear surfaces of the printed circuit board. Therefore, stresses during the cooling and hardening of the above-described thermoplastic resin become almost equal on both front and back surfaces of the above-described printed circuit board and hence it becomes possible to prevent the board from being deformed by the above-described stresses.

Such a resin encapsulated electronic component unit as described above can be advantageously manufactured by the following manufacturing method. In the above-described manufacturing method, the above-described insert molding is performed by use of a mold having a shape which ensures that the amount of the above-described thermoplastic resin which forms the above-described resin coating layer disposed on both front and back surfaces of the above-described printed circuit board is substantially symmetrically disposed on both front and back surfaces of the printed circuit board, and by disposing the printed circuit board within the cavity and simultaneously injecting the above-described thermoplastic resin to the sides of both front and back surfaces of the printed circuit board.

It is preferred that in a resin encapsulated electronic component unit in which the amount of the above-described thermoplastic resin forming the above-described resin coating layer is substantially symmetrically disposed on both front and back surfaces of the above-described printed circuit board, the above-described resin coating layer has a shape which matches contours of the above-described electronic components. Because the above-described resin coating layer has a shape which matches contours of the above-described electronic components, it is possible to reduce the required amount of the above-described thermoplastic resin forming the resin coating film.

Such a resin encapsulated electronic component unit as described above can be advantageously manufactured by the following manufacturing method. In the above-described manufacturing method, the above-described insert molding is performed by use of a mold comprising a cavity having a shape which matches a contour of the above-described printed circuit board on which the above-described electronic components are mounted.

Incidentally, in addition to the problem that the above-described thermoplastic resin injected into the above-described mold forms the above-described weld line, the above-described insert molding has the problem that the streams of the thermoplastic resin may sometimes entrap air and form voids. If the above-described voids are formed in the above-described resin coating layer, in a case where stresses are added after molding, cracks are liable to start at the voids, as with the above-described weld line.

In the above-described insert molding, in some manners of the arrangement of electronic components mounted on the above-described printed circuit board, the electronic components may sometimes be damaged by the pressure of the above-described thermoplastic resin injected into the above-described cavity during molding.

Therefore, a resin encapsulated electronic component unit of the present invention can be advantageously manufactured by the following manufacturing method. In the above-described manufacturing method, the above-described insert molding is performed by disposing within the cavity of the above-described mold, a printed circuit board on which a plurality of mounted electronic components are longitudinally arranged and a channel of the above-described thermoplastic resin is provided in a middle portion of width direction, and injecting the thermoplastic resin into one hollow portion and discharging gases in the cavity from the other hollow portion so that the thermoplastic resin is guided into the channel within the cavity and flows longitudinally of the printed circuit board.

The electronic components mounted on the above-described printed circuit board include relatively tall components, such as capacitors and cable connection members such as connectors. If such electronic components are disposed on the channel of the above-described thermoplastic resin, the flow of the thermoplastic resin is branched by the electronic components and divided into multiple streams, with the result that weld lines are liable to be formed in points where the streams join together. Furthermore, if the flow of the above-described thermoplastic resin is interfered with by the above-described electronic components, then the flow of the thermoplastic resin is liable to entrap air when the flow of the thermoplastic resin moves around the electronic components, with the result that the above-described voids are liable to be formed. Furthermore, if the above-described electronic components interfere with the flow of the above-described thermoplastic resin, the electronic components may sometimes be damaged by the pressure of the flow of the thermoplastic resin.

Therefore, in the above-described manufacturing method, the above-described insert molding is performed by disposing, within the cavity of the mold, the above-described printed circuit board in which the above-described plurality of electronic components are arranged longitudinally of the printed circuit board and in a middle portion of the width direction of the printed circuit board is formed a nonmounted area (ie an area which is free of electronic components) which is longitudinally configured. Because in the above-described printed circuit board the above-described electronic components are arranged longitudinally of the board, the above-described nonmounted area which is formed in a middle potion of the width direction of the printed circuit board provides the channel of the above-described thermoplastic resin. As a result, when the above-described thermoplastic resin is injected from the above-described hollow portion on one narrow side of the above-described board and gases in the cavity are discharged from the above-described hollow portion on the other narrow side, the thermoplastic resin flows smoothly in the above-described channel longitudinally of the printed circuit board.

Therefore, in the above-described manufacturing method, the flow of the above-described thermoplastic resin is less apt to be branched or interfered with by the above-described electronic components and the occurrence of weld lines and voids can be substantially suppressed. Furthermore, in the above-described manufacturing method, the channel of the above-described thermoplastic resin is formed in the above-described printed circuit board and, therefore, the above-described electronic components are less apt to be subjected to the pressure of the thermoplastic resin which is injected into the above-described cavity, with the result that it is possible to prevent damage to the electronic components due to the pressure.

This manufacturing method can be advantageously carried out by using a rectangular printed circuit board on which a plurality of electronic components are mounted, in which a plurality of the electronic components are arranged longitudinally of the printed circuit board and in a middle portion of the width direction of the printed circuit board is formed a nonmounted area which is longitudinally configured.

### BRIEF DESCRIPTION OF THE DRAWINGS

FIG. 1 is a plan view of an embodiment of a resin encapsulated electronic component unit of the present invention;
FIG. 2 is a plan view of an embodiment of a printed circuit board used in a method of manufacturing a resin encapsulated electronic component unit of the present invention; and
FIG. 3 is a schematic sectional view of an embodiment of a method of manufacturing a resin encapsulated electronic component unit of the present invention.

### DETAILED DESCRIPTION OF THE PREFERRED EMBODIMENTS

Next, embodiments of the present invention will be described in further detail by referring to the accompanying drawings.

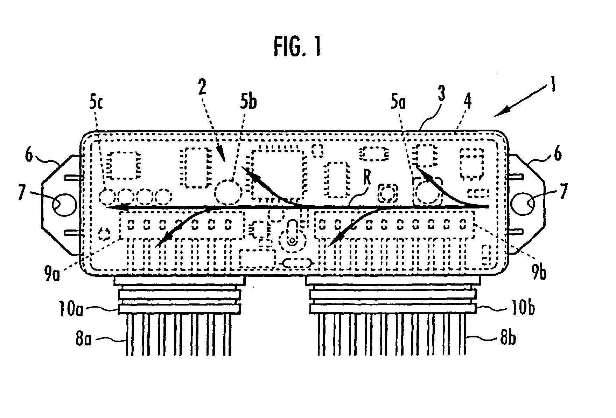

As shown in FIG. 1, a resin encapsulated electronic component unit 1 of this embodiment comprises a resin coating layer 3 on both front and back surfaces of a mounted printed circuit board 2. The mounted printed circuit board 2 is obtained by mounting a plurality of electronic components 5a, 5b, 5c such as semiconductors, LSIs and capacitors on one surface of a rectangular printed circuit board 4 by soldering.

The resin encapsulated electronic component unit 1 has attaching flanges 6 which are molded integrally with the resin coating layer 3 so as to be connected to both end portions of narrow sides of the printed circuit board 4, and an attaching hole 7 is provided in each of the flanges 6. Furthermore, the printed circuit board 4 is provided, on the surface thereof, with cable connection members 9a, 9b to which a plurality of groups of input/output cables 8a, 8b are connected, and the groups of cables 8a, 8b are pulled out of the printed circuit board 4 one by one via grommets 10a, 10b which are molded integrally with the resin coating layer 3 so as to be connected to the end portions of wide side of the printed circuit board 4. Incidentally, in this embodiment, the description will be given by regarding also the cable connection members 9a, 9b as electronic components.

In the mounted printed circuit board 2, tall electronic components such as capacitors 5a, 5b, 5c are arranged generally on a line extending longitudinally of the rectangular printed circuit board 4, the cable connection members 9a, 9b are arranged parallel to the line of electronic components 5a, 5b, 5c, and a nonmounted area, free of electronic components, is provided between the electronic components 5a, 5b, 5c and the cable connection members 9a, 9b.

The resin coating layer 3 is formed from a thermoplastic resin whose temperature at a surface of the mounted printed circuit board 2 during the molding is lower than the melting temperature of solder used in mounting the electronic components 5a, 5b, 5c. The above-described thermoplastic resin is, for example, a polyamide resin.

The resin encapsulated electronic component unit 1 of this embodiment is formed from a polyamide resin R which flows, as shown by the arrows in FIG. 1, from one flange 6 to the other flange 6. The above-described polyamide resin R flows using the above-described nonmounted area between the row of the electronic components 5a, 5b, 5c and the row of the cable connection members 9a, 9b as the channel. And the above-described polyamide resin R flows so as to spread from the above-described channel to both sides of width direction of the mounted printed circuit board 2.

As described above, the resin coating layer 3 is disposed on both front and back surfaces of the mounted printed circuit board 2 and the amount of the above-described polyamide resin R which forms the resin coating layer 3 is substantially symmetrically disposed on both front and back surfaces of the printed circuit board 2.

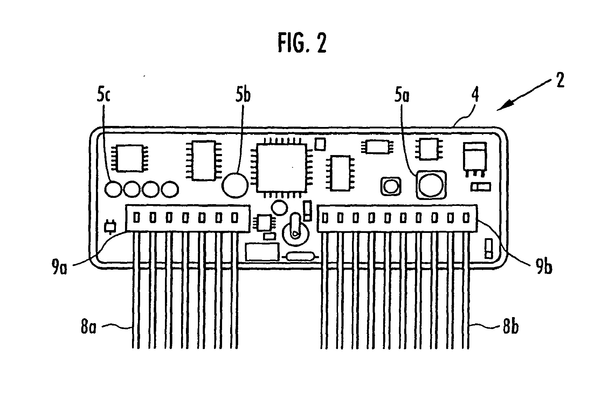

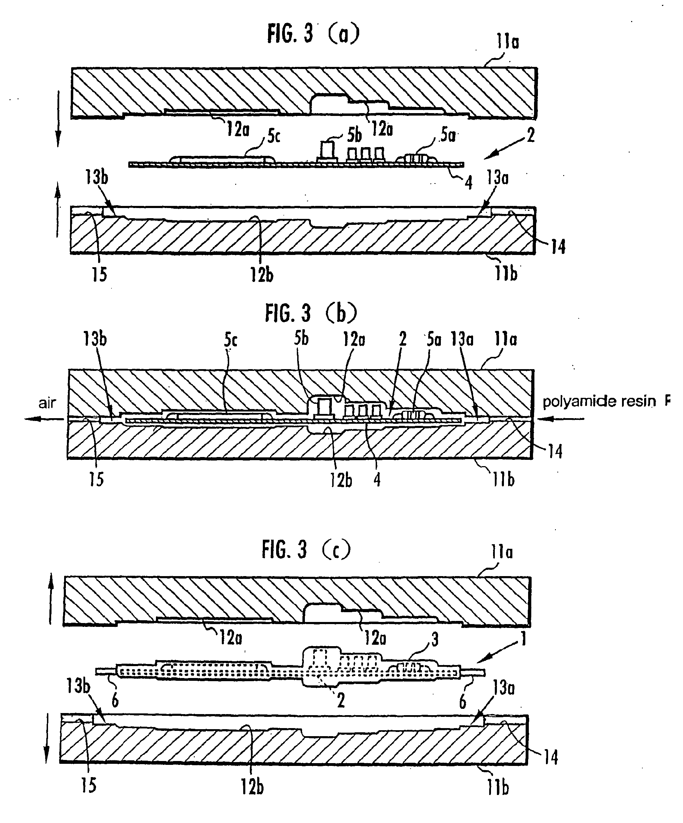

Next, a method of manufacturing the resin encapsulated electronic component 1 shown in FIG. 1 will be described below by referring to FIG. 2 and FIG. 3.

In a method of manufacturing a resin encapsulated electronic component of this embodiment, the mounted printed circuit board 2 shown in FIG. 2 is coated with the resin coating layer 3. In the mounted printed circuit board 2, as described above, the plurality of electronic components 5a, 5b, 5c such as semiconductors, LSIs and capacitors are mounted on one surface of the rectangular printed circuit board 4, and the plurality of groups of input/output cables 8a, 8b are connected to the cable connection members 9a, 9b provided on the surface. The tall electronic components 5a, 5b, 5c such as capacitors are arranged longitudinally of the rectangular printed circuit board 4, and the cable connection members 9a, 9b are arranged parallel to the electronic components 5a, 5b, 5c. Incidentally, the mounted printed circuit board 2 is not provided with the mounting flanges 6 or the grommets 10a, 10b.

In a method of manufacturing a resin encapsulated electronic component unit of this embodiment, first as shown in FIG. 3(a), the mounted printed circuit board 2 shown in FIG. 2 is disposed in cavities 12a, 12b of aluminum molds 11a, 11b. Incidentally, FIGS. 3(a) to 3(c) show the above-described cavities 12a, 12b and mounted printed circuit board 2 only schematically and there are portions which do not conform to the constructions shown in FIGS. 1 and 2.

The cavity 12a of the mold 11a has a shape which matches the contour of the mounted printed circuit board 2, more specifically, a shape which matches the contour of the electronic components 5a, 5b, 5c and cable connection members 9a, 9b mounted on the printed circuit board 4.

On the other hand, the cavity 12b of the mold 11b is provided with flange formation portions 13a, 13b for forming the flanges 6 between both end portions of short sides of the mounted printed circuit board 2 and the inner wall of the mold 11b opposed to the end portions. The mold 11b is provided with a runner 14 which is in communication with one flange formation portion 13a and injects the above-described polyamide resin R and an air vent 15 which is in communication with the other flange formation portion 13b and discharges air in the cavities 12a, 12b to outside.

The cavities 12a, 12b have a shape which ensures that the amount of the above-described polyamide resin R which is introduced is substantially symmetrically disposed on both front and back surfaces of the mounted printed circuit board 2. As a result of this, in a manufacturing method of this embodiment, in the resin coating layer 3 formed by the cavities 12a, 12b, the amount of the above-described polyamide resin R is almost equal on both front and back surfaces of the mounted printed circuit board 2 and hence it is possible to suppress the deformation of the mounted printed circuit board 2 due to stresses during the cooling and hardening of the polyamide resin R.

The above-described expression "substantially symmetrically" means that it is necessary only that the amount be large enough to suppress the deformation of the mounted printed circuit board 2 due to stresses during the cooling and hardening of the polyamide resin R, and the amount of the above-described polyamide resin R which is introduced is not necessarily completely symmetrically disposed on both front and back surfaces of the mounted printed circuit board 2.

Incidentally, the cavities 12a, 12b of the molds 11a, 11b are further provided, on one wide side of the mounted printed circuit board 2, with grommet formation portions (not shown) for forming the grommets 10a, 10b.

Next, as shown in FIG. 3 (b), the molds 11a, 11b are closed. At this time, the mounted printed circuit board 2 is held by holding pins (not shown) in a predetermined position.

Next, by injecting the above-described polyamide resin R from the gate provided at the boundary between the runner 14 and the cavities 12a, 12b, the polyamide resin R is introduced into the cavities 12a, 12b. The above-described polyamide resin R is beforehand heated to a temperature of 210 to 220°C and melted within a storage tank not shown in the figure and by use of a pressure feed pump provided within the storage tank the polyamide resin R is fed to the runner 14 at a pressure of about 1 to 4 MPa. As a result of this, the temperature of the above-described polyamide resin R becomes about 160°C when the polyamide resin R reaches the surface of the mounted printed circuit board 2 held within the cavities 12a, 12b. This temperature is lower than the melting point of a solder (Pb:Sn = 6:4 (weight ratio)) used in the mounting of the electronic components 5a, 5b, 5c.

During the injection of the above-described polyamide resin R, the mounted printed circuit board 2 is held in a position opposed to the runner 14 in the cavities 12a, 12b. Therefore, the above-described polyamide resin R is simultaneously injected to both front and back surface sides of the mounted printed circuit board 2.

At this time, in the mounted printed circuit board 2, as described above, the row of the electronic components 5a, 5b, 5c and the row of the cable connection members 9a, 9b are longitudinally formed and a nonmounted area is formed between the electronic components 5a, 5b, 5c and the cable connection members 9a, 9b. Therefore, as shown in FIG. 1, the above-described polyamide resin R flows in a middle portion of width direction of the mounted printed circuit board 2 using the above-described nonmounted area between the row of the electronic components 5a, 5b, 5c and the row of the cable connection members 9a, 9b as the channel.

On the other hand, the air in the cavities 12a, 12b is discharged from the air vent 15 provided on the side corresponding to the flange formation portion 13b as the above-described polyamide resin R is introduced into the cavities 12a, 12b. As a result of this, the above-described polyamide resin R flows in the above-described channel longitudinally of the mounted printed circuit board 2 and simultaneously flows so as to spread from the above-described channel to both sides of width direction of the mounted printed circuit board 2, thereby forming the resin coating layer 3. Therefore, the flow of the polyamide resin R in the cavities 12a, 12b scarcely forms points of joining due to mutual collision any more and it is possible to suppress the occurrence of weld lines in the formed resin coating layer 3.

Because the flow of the polyamide resin R is less apt to be interfered with by the electronic components 5a, 5b, 5c and the cable connection members 9a, 9b, it is possible to suppress the occurrence of voids by reducing the entrapment of air. Furthermore, because the electronic components 5a, 5b, 5c and the cable connection members 9a, 9b are arranged in positions where they are less apt to interfere with the flow of the polyamide resin R, the pressure of the flow of the polyamide resin R is substantially reduced.

The above-described polyamide resin R introduced into the cavities 12a, 12b releases heat in a short time via the aluminum molds 11a, 11b, is cooled and hardend, thereby forming the resin coating layer 3 which covers the mounted printed circuit board 2. At this time, the attaching flanges 6 and the grommets 10a, 10b are molded integrally with the resin coating layer 3.

Incidentally, the above-described holding pins are withdrawn the instant once the mounted printed circuit board 2 is supported by the above-described introduced polyamide resin R, and the polyamide resin R is filled in the traces of the holding pins. Therefore, the traces of the above-described holding pins do not remain in the resin coating layer 3.

Next, when the above-described polyamide resin R has been cooled and hardened, as shown in FIG. 3(c), the molds 11a, 11b are opened and the resin encapsulated electronic component unit 1 in which the mounted printed circuit board 2 is covered with the resin coating layer 3 is taken out.

In the resin encapsulated electronic component unit 1 of this embodiment, the occurrence of weld lines and voids is substantially suppressed in the resin coating layer 3 as described above and, therefore, cracks are less apt to occur when stresses are applied.

On the side where the electronic components 5a, 5b, 5c and cable connection members 9a, 9b of the mounted printed circuit board 2 are mounted, the resin coating layer 3 has a shape which matches the contours of the electronic components 5a, 5b, 5c and cable connection members 9a, 9b. On the side opposite to the side where the electronic components 5a, 5b, 5c and cable connection members 9a, 9b of the mounted printed circuit board 2 are mounted, the amount of the resin of each part of the resin coating layer 3 is disposed substantially symmetrically with the side where the electronic components 5a, 5b, 5c and cable connection members 9a, 9b are mounted.

Specifically, in portions where the resin coating layer 3 is formed thick by coating the electronic components 5a, 5b, 5c and the cable connection members 9a, 9b on the side where the electronic components 5a, 5b, 5c and the cable connection members 9a, 9b are mounted, the resin coating layer 3 is formed thick even on the side where the electronic components 5a, 5b, 5c and the cable connection members 9a, 9b are not mounted. Furthermore, in portions where the electronic components 5a, 5b, 5c and the cable connection members 9a, 9b are not present and the resin coating layer 3 is formed thin on the surface of the printed circuit board 2 on the side where the electronic components 5a, 5b, 5c and the cable connection members 9a, 9b are mounted, the resin coating layer 3 is formed thin even on the side where the electronic components 5a, 5b, 5c and the cable connection members 9a, 9b are not mounted.

As a result of this, in the resin coating layer 3 the amount of resin is almost equal on both front and back surfaces of the mounted printed circuit board 2 and hence stresses generated by the cooling and hardening are made equal on both front and back surfaces of the mounted printed circuit board 2. Therefore, in the resin encapsulated electronic component unit 1, it is possible to suppress deformation, such as bowing, of the mounted printed circuit board 2 due to the above-described stresses.

Furthermore, in the resin encapsulated electronic component unit 1 of this embodiment, the electronic components 5a, 5b, 5c and the cable connection members 9a, 9b are less apt to be subjected to the heat and pressure of the polyamide resin R and, therefore, it is possible to prevent damage by the heat and pressure.

In this embodiment, the flange 6 having the attaching hole 7 as an attaching member which attaches the resin encapsulated electronic component unit 1 in a prescribed position is used. However, the above-described attaching member may be of any kind so long as it can attach the resin encapsulated electronic component unit 1 in a predetermined position. Such attaching members include, for example, a flange 6 which has no attaching hole 7 and which simply inserts the resin encapsulated electronic component unit 1 into a hole provided in a receiving portion and fixes the resin encapsulated electronic component unit 1, and the like.

## Claims

1. A resin encapsulated electronic component unit [1] comprising a rectangular printed circuit board [4], electronic components [5a, 5b, 5c, 9a, 9b] mounted to the circuit board by means of a solder, and a resin coating layer [3] which covers the electronic components [5a,5b,5c,9a,9b] by insert molding and encapsules the electronic components, the resin coating layer being formed from a thermoplastic resin whose temperature at a surface of the printed circuit board [4] during the insert molding is lower than the melting temperature of the solder used to mount the electronic components [5a,5b,5c,9a,9b] to the circuit board, accessory members [6] being connected to both end portions of narrow sides of the printed circuit board [4] and molded integrally with the resin coating layer [3] from the thermoplastic resin, the resin coating layer [3] being formed by causing the thermoplastic resin to flow from the side of one accessory member [6] to the side of the other accessory member [6] **characterised in that** the solder is an alloy of Pb 60 wt% and Sn 40 wt% and that the thermoplastic resin is a polyamide resin.

2. A resin encapsulated electronic component unit [1] as claimed in claim 1, **characterised in that** said accessory members [6] are attaching members which attach said resin encapsulated electronic component unit [1] in a predetermined position.

3. A resin encapsulated electronic component unit [1] as claimed in claim 1 or 2, **characterised in that** said resin coating layer [3] is disposed on both front and back surfaces of said printed circuit board [4] and the amount of said thermoplastic resin which forms the resin coating layer [3] is substantially symmetrically disposed on both front and back surfaces of the printed circuit board [4].

4. A resin encapsulated electronic component unit [1] as claimed in claim 3, **characterized in that** said resin coating layer [3] has a shape which matches contours of said electronic components [5a,5b,5c,9a,9b].

5. A resin encapsulated electronic component unit [1] as claimed in any one of the preceding claims, **characterised in that** a plurality of the electronic components [5a,5b,5c,9a,9b] are arranged longitudinally of the printed circuit board [4] and a longitudinally configured nonmounted area is formed in a middle portion of the width direction of the printed circuit board [4].

6. A method of manufacturing a resin encapsulated electronic component unit [1] comprising a rectangular printed circuit board [4], electronic components [5a, 5b, 5c, 9a, 9b] mounted to the circuit board 4 by means of a solder, a resin coating layer [3] which covers the electronic components [5a,5b,5c,9a,9b] by insert molding and encapsulates the electronic components [5a,5b,5c,9a,9b], the resin coating layer [3] being formed from a thermoplastic resin whose temperature at a surface of the printed circuit board [4] during the insert molding is lower than the melting temperature of the solder used to mount the electronic components [5a,5b,5c,9a,9b] to the circuit board 4, and accessory members [6] which are connected to both end portions of narrow sides of the printed circuit board [4] and molded integrally with the resin coating layer [3] from the thermoplastic resin,
wherein the insert molding is performed by use of a mold [11a, 11b] which comprises a cavity [12a,12b] in which the printed circuit board [4] is disposed, and hollow portions [13a,13b] corresponding to the shape of the accessory members [6] formed between each end portion on narrow sides of said printed circuit board [4] disposed within the cavity [12a, 12b] and an inner wall of the cavity [12a,12b], and by injecting the thermoplastic resin into one hollow portion and discharging gases in the cavity [12a,12b] from the other hollow portion so that the thermoplastic resin flows within the cavity longitudinally of the board **characterised in that** the solder is an alloy of Pb 60 wt% and Sn 40 wt% and that the thermoplastic resin is a polyamide resin.

7. A method of manufacturing a resin encapsulated electronic component unit [1] as claimed in claim 6, **characterised in that** said accessory members [6] are attaching members which attach said resin encapsulated electronic component unit [1] in a predetermined position.

8. A method of manufacturing a resin encapsulated electronic component unit 1 as claimed in claim 6 or 7, **characterised in that** said insert molding is performed by use of a mold [11a,11b] having a shape which ensures that the amount of said thermoplastic resin which forms said resin coating layer disposed on both front and back surfaces of said printed circuit board [4] is substantially symmetrically disposed on both front and back surfaces of the printed circuit board [4], and by disposing the printed circuit board [4] within the cavity [12a,12b] and simultaneously injecting said thermoplastic resin to the sides of both front and back surfaces of the printed circuit board [4].

9. A method of manufacturing a resin encapsulated electronic component unit [1] as claimed in claim 8, **characterised in that** said insert molding is performed by use of a mold comprising a cavity [12a,12b] having a shape which matches the contour of said printed circuit board [4] on which said electronic components are mounted.

10. A method of manufacturing a resin encapsulated electronic component unit [1] as claimed in any one of claims 6 to 9, **characterised in that** said insert molding is performed by disposing within the cavity [12a,12b] of said mold [11a,11b], a printed circuit board [4] on which a plurality of mounted electronic components [5a,5b,5c,9a,9b] are longitudinally arranged and a channel of said thermoplastic resin is provided in a middle portion of width direction, and injecting the thermoplastic resin into one hollow portion and discharging gases in the cavity [12a,12b] from the other hollow portion so that the thermoplastic resin is guided into the channel within the cavity [12a,12b] and flows longitudinally of the printed circuit board [4].

## Patentansprüche

1. Harzummantelte Elektronikbaueinheit (1), umfassend eine rechteckige Platine (4), Elektronikbauteile (5a, 5b, 5c, 9a, 9b), die mit Hilfe von Lot an der Platine befestigt sind, und eine Harzmantelschicht (3), die die Elektronikbauteile (5a, 5b, 5c, 9a, 9b) nach dem Umspritzen bedeckt und die Elektronikbauteile ummantelt, wobei die Harzmantelschicht aus einem Thermoplastharz hergestellt ist, dessen Temperatur an einer Oberfläche der Platine (4) beim Umspritzen niedriger ist als die Schmelztemperatur des Lots, das zur Befestigung der Elektronikbauteile (5a, 5b, 5c, 9a, 9b) an der Platine verwendet wird, Hilfselemente (6), die an beide Endabschnitte der schmalen Seiten der Platine (4) angeschlossen sind und einstückig mit der Harzmantelschicht (3) aus dem Thermoplastharz geformt werden, wobei die Harzmantelschicht (3) gebildet wird, indem man dafür sorgt, dass das Thermoplastharz von der Seite eines Hilfselements (6) zur Seite des anderen Hilfselements (6) fließt, **dadurch gekennzeichnet, dass** das Lot eine Legierung ist aus 60 Gewichtsprozent Pb und 40 Gewichtsprozent Sn ist, und dass das Thermoplastharz ein Polyamidharz ist.

2. Harzummantelte Elektronikbaueinheit (1) nach Anspruch 1, **dadurch gekennzeichnet, dass** die Hilfselemente (6) Befestigungselemente sind, die die harzummantelte Elektronikbaueinheit (1) in einer festgelegten Position binden.

3. Harzummantelte Elektronikbaueinheit (1) nach Anspruch 1 oder 2, **dadurch gekennzeichnet, dass** sich die Harzmantelschicht (3) sowohl auf der Vorder- als auch auf der Rückseite der Platine (4) befindet und die Menge Thermoplastharz, die die Harzmantelschicht (3) bildet, im Wesentlichen symmetrisch auf Vorder- und Rückseite der Platine (4) angeordnet ist.

4. Harzummantelte Elektronikbaueinheit (1) nach Anspruch 3, **dadurch gekennzeichnet, dass** die Form der Harzmantelschicht (3) den Umrissen der Elektronikbauteile (5a, 5b, 5c, 9a, 9b) entspricht.

5. Harzummantelte Elektronikbaueinheit (1) nach einem der vorhergehenden Ansprüche, **dadurch gekennzeichnet, dass** eine Anzahl Elektronikbauteile (5a, 5b, 5c, 9a, 9b) in Längsrichtung der Platine (4) angeordnet ist, und ein längs konfigurierter, nicht befestigter Bereich in einem Mittelabschnitt der Breitenrichtung der Platine (4) gebildet ist.

6. Verfahren zur Herstellung einer harzummantelten Elektronikbaueinheit (1), umfassend eine rechteckige Platine (4), Elektronikbauteile (5a, 5b, 5c, 9a, 9b), die mit einem Lot an der Platine (4) befestigt sind, eine Harzmantelschicht (3), die die Elektronikbauteile (5a, 5b, 5c, 9a, 9b) nach dem Umspritzen bedeckt und die Elektronikbauteile (5a, 5b, 5c, 9a, 9b) ummantelt, wobei die Harzmantelschicht (3) aus einem Thermoplastharz hergestellt ist, dessen Temperatur an einer Oberfläche der Platine (4) beim Umspritzen niedriger ist als die Schmelztemperatur des Lots, das zur Befestigung der Elektronikbauteile (5a, 5b, 5c, 9a, 9b) an der Platine (4) verwendet wird, und Hilfselemente (6), die an beide Endabschnitte der schmalen Seiten der Platine (4) angeschlossen sind und einstückig mit der Harzmantelschicht (3) aus dem Thermoplastharz geformt sind, wobei das Umspritzen erfolgt, indem man eine Form (11a, 11b) verwendet, umfassend einen Hohlraum (12a, 12b), in der sich die Platine (4) befindet, und Hohlabschnitte (13a, 13b), die der Form der Hilfselemente (6) entsprechen, die sich zwischen dem Endabschnitt auf den schmalen Seiten der im Hohlraum (12a, 12b) angeordneten Platine (4) und einer Innenwand des Hohlraums (12a, 12b) befinden, und das Thermoplastharz in einen Hohlabschnitt spritzt und die Gase in den Hohlraum (12a, 12b) aus dem anderen Hohlabschnitt auslässt, so dass das Thermoplastharz innerhalb des Hohlraums in Längsrichtung der Platine fließt, **dadurch gekennzeichnet, dass** das Lot eine Legierung aus 60 Gewichtsprozent Pb und 40 Gewichtsprozent Sn ist, und dass das Thermoplastharz ein Polyamidharz ist.

7. Verfahren zur Herstellung einer harzummantelten Elektronikbaueinheit (1) nach Anspruch 6, **dadurch gekennzeichnet, dass** die Hilfselemente (6) Befestigungselemente sind, die die harzummantelte Elektronikbaueinheit (1) in einer festgelegten Position befestigen.

8. Verfahren zur Herstellung einer harzummantelten Elektronikbaueinheit (1) nach Anspruch 6 oder 7, **dadurch gekennzeichnet, dass** man das Umspritzen mit einer Form (11a, 11 b) durchführt, deren Form gewährleistet, dass die Menge Thermoplastharz, die die sowohl auf der Vorder- als auch auf der Rückseite der Platine (4) angeordnete Harzmantelschicht bildet, im Wesentlichen symmetrisch auf der Vorder- und Rückseite der Platine (4) angeordnet ist, und man die Platine (4) in dem Hohlraum (12a, 12b) anordnet und gleichzeitig das Thermoplastharz auf die Seiten der Vorder- und Rückseiten der Platine (4) spritzt.

9. Verfahren zur Herstellung einer harzummantelten Elektronikbaueinheit (1) nach Anspruch 8, **dadurch gekennzeichnet, dass** man das Umspritzen durchführt, indem man eine Form mit einem Hohlraum (12a, 12b) verwendet, dessen Gestalt dem Umriss der Platine (4) entspricht, auf der die Elektronikbauteile befestigt werden.

10. Verfahren zur Herstellung einer harzummantelten Elektronikbaueinheit (1) nach einem der Ansprüche 6 bis 9, **dadurch gekennzeichnet, dass** man das Umspritzen durchführt, indem man in Hohlraum (12a, 12b) der Form (11a, 11 b) eine Platine (4) anordnet, auf der sich eine Anzahl von befestigten Elektronik-Komponenten (5a, 5b, 5c, 9a, 9b) in Längsrichtung befindet, eine Rinne für das Thermoplastharz in einem Mittelabschnitt der Breitenrichtung bereitstellt, das Thermoplastharz in einen Hohlabschnitt spritzt und die Gase in den Hohlraum (12a, 12b) aus dem anderen Hohlabschnitt auslässt, so dass das Thermoplastharz in die Rinne im Hohlraum (12a, 12b) geleitet wird und in Längsrichtung der Platine (4) fließt.

## Revendications

1. Unité de composant électronique encapsulée dans une résine [1] comprenant une carte de circuit imprimé conducteur [4], des composants électroniques [5a, 5b, 5c, 9a, 9b] montés sur la carte de circuit au moyen d'une brasure tendre et une couche de revêtement en résine [3] qui couvre les composants électroniques [5a, 5b, 5c, 9a, 9b] pour moulage par insertion et encapsule les composants électroniques, la couche de revêtement en résine étant formée à partir d'une résine thermoplastique dont la température au niveau d'une surface de la carte de circuit imprimé [4] au cours du moulage par insertion est inférieure à la température de fusion de la brasure tendre utilisée pour monter les composants électroniques [5a, 5b, 5c, 9a, 9b] à la carte de circuit, des éléments accessoires [6] étant reliés aux deux portions d'extrémité de côtés étroits de la carte de circuit imprimé [4] et moulés solidairement avec la couche de revêtement en résine [3] à partir de la résine thermoplastique, la couche de revêtement en résine [3] étant formée en provoquant l'écoulement de la résine thermoplastique du côté d'un élément accessoire [6] vers le côté de l'autre élément accessoire [6], **caractérisée en ce que** la brasure tendre est un alliage de Pb à 60 % en poids et de Sn à 40 % en poids et **en ce que** la résine thermoplastique est une résine poly (amide) .

2. Unité de composant électronique encapsulée dans une résine [1] selon la revendication 1, **caractérisée en ce que** lesdits éléments accessoires [6] sont des éléments de fixation qui fixent ladite unité de commande électronique encapsulée dans une résine [1] dans une position prédéterminée.

3. Unité de composant électronique encapsulée dans une résine [1] selon la revendication 1 ou 2, **caractérisée en ce que** ladite couche de revêtement en résine [3] est disposée à la fois sur la surface avant et sur la surface arrière de ladite carte de circuit imprimé [4] et la quantité de ladite résine thermoplastique qui forme la couche de revêtement en résine [3] est disposée de manière sensiblement symétrique à la fois sur la surface avant et sur la surface arrière de la carte de circuit imprimé [4].

4. Unité de composant électronique encapsulée dans une résine [1] selon la revendication 3, **caractérisée en ce que** ladite couche de revêtement en résine [3] a une forme qui correspond aux contours desdits composants électroniques [5a, 5b, 5c, 9a, 9b].

5. Unité de composant électronique encapsulée dans une résine [1] selon l'une quelconque des revendications précédentes, **caractérisée en ce qu'**une pluralité de composants électroniques [5a, 5b, 5c, 9a, 9b] est agencée de façon longitudinale sur la carte de circuit imprimé [4] et **en ce qu'**une région non montée configurée de manière longitudinale est formée dans une portion médiane dans le sens de la largeur de la carte de circuit imprimé [4].

6. Procédé de fabrication d'une unité de composant électronique encapsulée dans une résine [1] comprenant une carte de circuit imprimé rectangulaire [4], des composants électroniques [5a, 5b, 5c, 9a, 9b] montés sur la carte de circuit 4 au moyen d'une brasure tendre et une couche de revêtement en résine [3] qui couvre les composants électroniques [5a, 5b, 5c, 9a, 9b] pour moulage par insertion et encapsule les composants électroniques [5a, 5b, 5c, 9a, 9b], la couche de revêtement en résine [3] étant formée à partir d'une résine thermoplastique dont la température au niveau d'une surface de la carte de circuit imprimé [4] au cours du moulage par insertion est inférieure à la température de fusion de la brasure tendre utilisée pour monter les composants électroniques [5a, 5b, 5c, 9a, 9b] à la carte de circuit 4, et des éléments accessoires [6] étant reliés aux deux portions d'extrémité de côtés étroits de la carte de circuit imprimé [4] et moulés solidairement avec la couche de revêtement en résine [3] à partir de la résine thermoplastique,
dans lequel le moulage par insertion est réalisé grâce à l'utilisation d'un moule [11a, 11b] qui comprend une cavité [12a, 12b] dans laquelle la carte de circuit imprimé [4] est disposée, et des portions creuses [13a, 13b] correspondant à la forme des éléments accessoires (6] formées entre chaque portion d'extrémité sur les côtés de ladite carte de circuit imprimé [4] disposée dans la cavité [12a, 12b] et une paroi interne de la cavité [12a, 12b], et en injectant la résine thermoplastique à l'intérieur d'une portion creuse et en évacuant les gaz dans la cavité [12a, 12b] par l'autre portion creuse de sorte que la résine thermoplastique s'écoule dans la cavité de façon longitudinale par rapport à la carte, **caractérisé en ce que** la brasure tendre est un alliage de Pb à 60 % en poids et de Sn à 40 % en poids et **en ce que** la résine thermoplastique est une résine poly(amide).

7. Procédé de fabrication d'une unité de composant électronique encapsulée dans une résine [1] selon la revendication 6, **caractérisé en ce que** lesdits éléments accessoires [6] sont des éléments de fixation qui fixent ladite unité de commande électronique encapsulée dans une résine [1] dans une position prédéterminée.

8. Procédé de fabrication d'une unité de composant électronique encapsulée dans une résine 1 selon la revendication 6 ou 7, **caractérisé en ce que** ledit moulage par insertion est réalisé grâce à l'utilisation d'un moule [11a, 11b] ayant une forme qui garantit que la quantité de ladite résine thermoplastique qui forme ladite couche de revêtement en résine disposée à la fois sur la surface avant et la surface arrière de ladite carte de circuit imprimé [4] est disposée de manière sensiblement symétrique à la fois sur la surface avant et la surface arrière de la carte de circuit imprimé [4] et en disposant la carte de circuit imprimé [4] dans la cavité [12a, 12b] et en injectant simultanément ladite résine thermoplastique sur les côtés à la fois de la surface avant et de la surface arrière de la carte de circuit imprimé [4].

9. Procédé de fabrication d'une unité de composant électronique encapsulée dans une résine [1] selon la revendication 8, **caractérisé en ce que** ledit moulage par insertion est réalisé grâce à l'utilisation d'un moule comprenant une cavité [12a, 12b] ayant une forme qui correspond au contour de ladite carte de circuit imprimé [4] sur laquelle sont montés lesdits composants électroniques.

10. Procédé de fabrication d'une unité de composant électronique encapsulée dans une résine [1] selon l'une quelconque des revendications 6 à 9, **caractérisé en ce que** ledit moulage par insertion est réalisé en disposant dans la cavité [12a, 12b] dudit moule [11a, 11b] une carte de circuit imprimé [4] sur laquelle une pluralité de composants électroniques montés [5a, 5b, 5c, 9a, 9b] est agencée de façon longitudinale et un canal de ladite résine thermoplastique est disposé dans une portion médiane dans le sens de la largeur et en injectant la résine thermoplastique dans une portion creuse et en évacuant les gaz dans la cavité [12a, 12b] par l'autre portion creuse, de sorte que la résine thermoplastique est guidée dans le canal dans la cavité [12a, 12b] et s'écoule longitudinalement par rapport à la carte de circuit imprimé [4].
